# EUROPEAN PATENT APPLICATION

(11) **EP 4 397 986 A1**
(43) Date of publication of application: **10.07.2024**
(21) Application number: 21955887.1
(22) Date of filing: 30.08.2021
(51) Int. Cl.: G01R 31/392

(54) **DETERIORATION STATE ESTIMATION DEVICE, DETERIORATION STATE ESTIMATION METHOD, AND PROGRAM**

(71) Applicant: Terawatt Technology K.K., Yokohama-shi, Kanagawa 226-0026 (JP)
(72) Inventor: ARAI, Juichi, Yokohama-shi, Kanagawa 226-0026 (JP); OGATA, Ken, Yokohama-shi, Kanagawa 226-0026 (JP); IMOTO, Hiroshi, Yokohama-shi, Kanagawa 226-0026 (JP)
(74) Representative: Mewburn Ellis LLP
(86) International application number: PCT/JP2021/031689
(87) International publication number: WO 2023/031990

(57) **Abstract**

To provide a deterioration state estimation device capable of highly accurately estimating the deterioration state and the service life of a secondary battery whose negative electrode does not contain a negative electrode active material with a simple configuration. The deterioration state estimation device according to an aspect of the present invention includes a thickness measurement value acquisition unit that acquires a thickness measurement value which is a measurement value of a thickness of a predetermined portion including at least a negative electrode of a secondary battery whose negative electrode does not contain a negative electrode active material, a charged state estimation unit that calculates a charge index estimation value which is an estimation value of a charge index indicating a charged state of the secondary battery, a deterioration state estimation unit that, by referring to at least any one of deterioration characteristic information after full charge that defines a relationship between the thickness after full charge and a deterioration index indicating a deterioration state of the secondary battery and deterioration characteristic information after complete discharge that defines a relationship between the thickness after complete discharge and the deterioration index, calculates a deterioration index estimation value which is an estimation value of the deterioration index for the secondary battery, based on the thickness measurement value and the charge index estimation value, and an output unit that outputs the calculated deterioration index estimation value.

## Description

### Background

### Field

The present invention relates to a deterioration state estimation device, a deterioration state estimation method, and a program.

### Description of Related Art

Secondary batteries are known to deteriorate after repeated charge and discharge during use. Therefore, various methods for estimating the deterioration state of secondary batteries have been proposed.

For example, Japanese Patent Application Laid-Open No. H06-089745 describes a secondary power supply device that estimates the remaining cycle life from the number of cycles until the number of cycles reaches a set value by extrapolating a discharge capacity for each cycle or a rate of change in voltage at the time when discharge ends in a battery group formed of a plurality of secondary batteries connected in series. Further, for example, Japanese Patent Application Laid-Open No. 2007-195312 describes a service life measuring device in which a correlation function is determined so as to have a high correlation value with the accumulated full charge capacity or internal resistance of a secondary battery, the point at which the determined correlation function intersects a service life determining line is determined to be the service life of the secondary battery, and the distance traveled up to the service life is estimated to be the remaining service life.

### Summary

However, estimating the deterioration state using these methods described above requires a large number of calculations which complicates the calculation process, and impedes the accuracy of estimates in many cases. As described above, it is not easy to estimate the deterioration state of a lithium ion battery in the related art. In addition, there is no known method for accurately estimating the deterioration state of a secondary battery whose negative electrode does not contain a negative electrode active material.

It is an object of the present invention to provide a deterioration state estimation device, a deterioration state estimation method, and a program capable of highly accurately estimating the deterioration state of a secondary battery whose negative electrode does not contain a negative electrode active material with a simple configuration.

As a result of extensive investigations regarding this point, the present applicant has found that in a secondary battery whose negative electrode does not contain a negative electrode active material, the linearity between the thickness of a predetermined portion of the secondary battery at least including the negative electrode and the deterioration index of the secondary battery is significant.

According to an aspect of the present invention, there is provided a deterioration state estimation device including: a thickness measurement value acquisition unit that acquires a thickness measurement value which is a measurement value of a thickness of a predetermined portion including at least a negative electrode of a secondary battery whose negative electrode does not contain a negative electrode active material; a charged state estimation unit that calculates a charge index estimation value which is an estimation value of a charge index indicating a charged state of the secondary battery; a deterioration state estimation unit that, by referring to at least any one of deterioration characteristic information after full charge that defines a relationship between the thickness after full charge and a deterioration index indicating a deterioration state of the secondary battery and deterioration characteristic information after complete discharge that defines a relationship between the thickness after complete discharge and the deterioration index, calculates a deterioration index estimation value which is an estimation value of the deterioration index for the secondary battery, based on the thickness measurement value and the charge index estimation value; and an output unit that outputs the calculated deterioration index estimation value.

According to this aspect, for the secondary battery whose negative electrode does not contain a negative electrode active material, a deterioration index estimation value can be calculated based on the thickness measurement value and the charge index estimation value and output by referring to at least any one of deterioration characteristic information after full charge and deterioration characteristic information after complete discharge. As described above, since the deterioration index can be measured based on the thickness measurement of the predetermined portion of the secondary battery and the estimation of the charge index of the secondary battery after the deterioration characteristic information after full charge and the deterioration characteristic information after complete discharge are prepared in advance, the deterioration state can be easily estimated. Further, since the negative electrode does not contain a negative electrode active material in the secondary battery whose deterioration state is to be estimated, both the deterioration characteristic information after full charge and the deterioration characteristic information after complete discharge exhibit strong linearity, which improves the accuracy of estimating the deterioration state.

According to the present invention, it is possible to provide deterioration state estimation device, a deterioration state estimation method, and a program capable of highly accurately estimating the deterioration state and the service life of a secondary battery whose negative electrode does not contain a negative electrode active material with a simple configuration.

### Brief Description of Drawings

FIG. 1 is a block diagram illustrating an example of a schematic configuration of a power supply device 1 according to the present embodiment.
FIG. 2 is a schematic cross-sectional view of a lithium secondary battery 101 according to the present embodiment.
FIG. 3 is a block diagram illustrating an example of a functional configuration of a BMS 400 according to the present embodiment.
FIG. 4 is a diagram illustrating examples of charge and discharge characteristic information according to the present embodiment.
FIG. 5 is a diagram illustrating examples of deterioration characteristic information after full charge and deterioration characteristic information after complete discharge according to the present embodiment.
FIG. 6 is a diagram illustrating an example of an operation flow of a deterioration state estimation process by the power supply device 1 according to the present embodiment.
FIG. 7 is a diagram for describing a calculation method of an estimation value of a full charge capacity decrease.

### Detailed Description

A preferred embodiment of the present invention will now be described with reference to the appended drawings. Note that similar or identical configurations in each drawing are denoted by the same reference numerals.

### [Configuration of Power Supply Device 1]

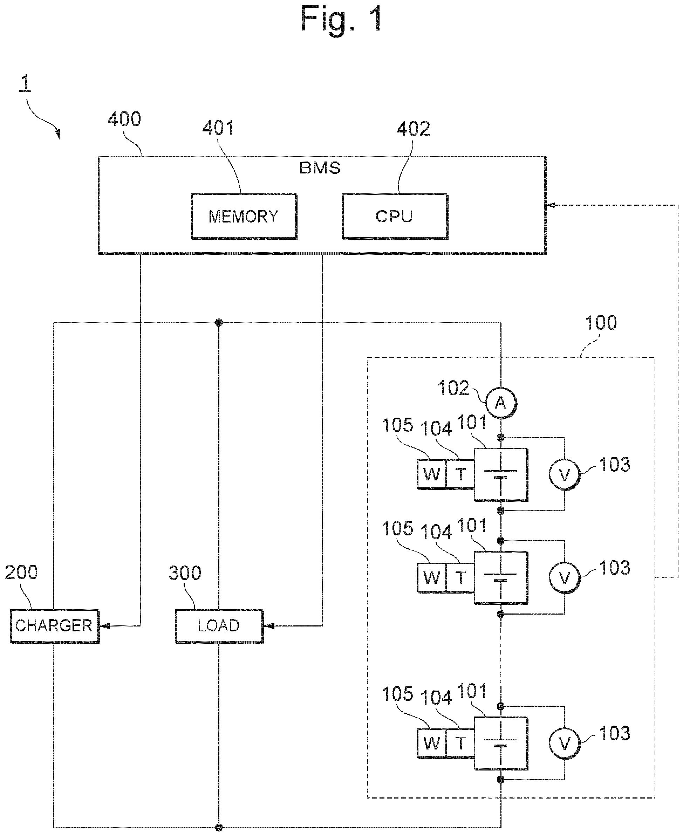

FIG. 1 is a block diagram illustrating an example of a schematic configuration of a power supply device 1 according to the present embodiment.

The power supply device 1 includes, for example, a battery module 100, a charger 200, a load 300, and a battery management system (BMS) 400.

The battery module 100 includes a plurality of lithium secondary batteries 101 connected in series. The lithium secondary battery 101 may form one secondary battery cell. The number of the lithium secondary batteries 101 included in the battery module 100 is not particularly limited. The plurality of lithium secondary batteries 101 may have the same characteristics or different characteristics. At least some of the lithium secondary batteries 101 included in the battery module 100 may be connected in parallel. The configuration of the lithium secondary battery 101 will be described later in detail.

The battery module 100 further has a current sensor 102 connected in series with the plurality of lithium secondary batteries 101. The current sensor 102 is connected in series with the plurality of lithium secondary batteries 101, detects the current flowing through the lithium secondary batteries 101, and supplies the current value to the BMS 400.

The battery module 100 further has a voltage sensor 103 provided in parallel for each of the plurality of lithium secondary batteries 101. Each of these voltage sensors 103 detects a voltage (inter-terminal voltage) between the positive electrode terminal and the negative electrode terminal of the lithium secondary battery 101, and supplies the voltage value to the BMS 400.

The battery module 100 further has a temperature sensor 104 provided for each of the plurality of lithium secondary batteries 101. Each of these temperature sensors 104 is thermally coupled to each of the lithium secondary batteries 101, detects the temperature of each of the lithium secondary batteries 101, and supplies the temperature value to the BMS 400.

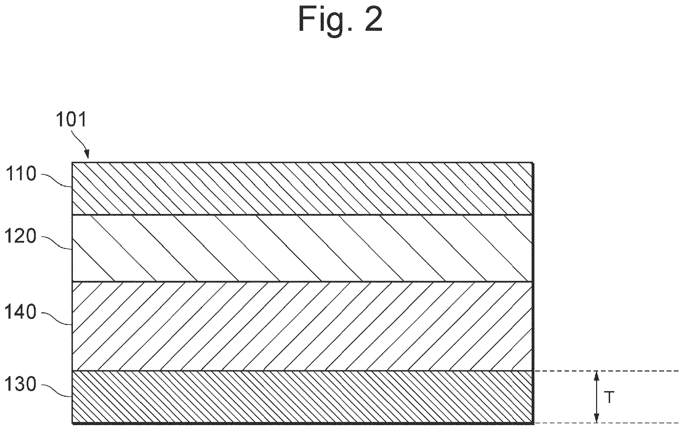

The battery module 100 further has a thickness sensor 105 provided for each of the plurality of lithium secondary batteries 101. Each of these thickness sensors 105 has, for example, an optional configuration capable of measuring the thickness of a pressure sensor, a displacement sensor, or the like, measures the thickness of a predetermined portion of the lithium secondary battery 101, and supplies the measurement value to the BMS 400. The predetermined portion of the lithium secondary battery 101 from which the thickness sensor 105 measures the thickness may be any portion (including the whole) as long as the portion is defined to include at least a negative electrode 130 which will be described later. For example, the predetermined portion may be a portion from one end to the other end of a sealed container of the lithium secondary battery 101 or may be a portion formed only of the negative electrode 130. That is, although a thickness T of the negative electrode 130 is shown in the schematic cross-sectional view of the lithium secondary battery 101 shown in FIG. 2, the predetermined portion of the lithium secondary battery 101 from which the thickness sensor 105 measures the thickness may be defined to at least include the portion of the thickness T of the negative electrode 130. Therefore, the thickness sensor 105 may be capable of measuring the thickness of the predetermined portion including the thickness T of the negative electrode 130 shown in FIG. 2.

The configuration of the charger 200 is not particularly limited, and for example, a charging connector connectable to a charging plug connected to an external power supply may be provided and may be configured to convert power supplied from the external power supply into charging power of the lithium secondary battery 101. The lithium secondary battery 101 can be, for example, connected to the charger 200, and charged with a charging current supplied by the charger 200 under the control of the BMS 400.

The configuration of the load 300 is not particularly limited, and may be configured as, for example, a drive device for an electric vehicle (electric car, hybrid car), or the like and can be driven by the power supplied from the lithium secondary battery 101. The lithium secondary battery 101 can be, for example, connected to the load 300 to supply a current to the load 300 under the control of the BMS 400 for discharge.

The BMS 400 is a controller that includes, for example, a memory 401 and a CPU 402, and controls the charge and discharge of the lithium secondary battery 101 included in the battery module 100.

The memory 401 includes, for example, a RAM, a ROM, a semiconductor memory, a magnetic disk device, an optical disk device, and the like, and stores driver programs, operating system programs, application programs, and data used by the CPU 402 to execute processing. The various programs may be installed in a memory unit 410 using any known set-up program from a computer-readable portable recording medium such as a CD-ROM or a DVD-ROM.

The CPU 402 includes one or a plurality of processors and peripheral circuits thereof, and collectively controls the overall operation of the BMS 400. The CPU 402 executes processing based on programs (operating system programs, driver programs, application programs, and the like) stored in the memory 401.

### [Lithium Secondary Battery 101]

FIG. 2 is a schematic cross-sectional view of the lithium secondary battery 101 according to the present embodiment. The lithium secondary battery 101 in the present embodiment includes a positive electrode 120 and a negative electrode 130 which does not have a negative electrode active material. In addition, in the lithium secondary battery 101, a positive electrode current collector 110 is arranged on a side of the positive electrode 120, opposite to a surface facing the negative electrode 130, and a separator 140 is arranged between the positive electrode 120 and the negative electrode 130.

The lithium secondary battery 101 of the present embodiment is typically a liquid electrolyte-based lithium secondary battery (particularly a non-aqueous electrolytic solution-based lithium secondary battery) having an electrolytic solution, a solid or semi-solid electrolyte-based lithium secondary battery having a polymer electrolyte, or a gel electrolyte-based lithium secondary battery having a gel electrolyte. However, as long as the problem of the present invention is solved, the lithium secondary battery 101 of the present embodiment may be, for example, an all-solid-state battery including an inorganic solid electrolyte, other than the above-described lithium secondary battery.

Hereinafter, each configuration will be described in detail.

### (Negative Electrode)

The negative electrode 130 does not have a negative electrode active material. In the present specification, the "negative electrode active material" is a material that causes an electrode reaction, that is, an oxidation reaction and a reduction reaction at the negative electrode. Examples of the negative electrode active material in the present specification include a lithium metal and a host material for a lithium element (lithium ions or lithium metal). The host material for the lithium element means a material provided to retain the lithium ions or the lithium metal in the negative electrode. Such a retaining mechanism is not particularly limited, and examples thereof include intercalation, alloying, and occlusion of metallic clusters, and intercalation or the like is typically used.

In the lithium secondary battery of the present embodiment, since the negative electrode does not have a negative electrode active material before the initial charge of the battery, charge and discharge are performed by precipitating a lithium metal on the negative electrode and electrolytically dissolving the precipitated lithium metal. Therefore, in the lithium secondary battery 101 of the present embodiment, the volume occupied by the negative electrode active material and the mass of the negative electrode active material are reduced as compared with a lithium secondary battery 101 having the negative electrode active material, and the volume and mass of the entire battery are small, so that the energy density is high in principle.

In the lithium secondary battery 101 of the present embodiment, the negative electrode does not have a negative electrode active material before the initial charge of the battery, a lithium metal is precipitated on the negative electrode when the battery is charged, and the precipitated lithium metal is electrolytically dissolved when the battery is discharged. Therefore, in the lithium secondary battery 101 in the present embodiment, the negative electrode does not substantially have the negative electrode active material even at the end of discharge of the battery. Therefore, in the lithium secondary battery 101 of the present embodiment, the negative electrode serves as a negative electrode current collector.

In the present specification, the expression "lithium metal is precipitated on the negative electrode" includes not only the precipitation of the lithium metal on the surface of the negative electrode, but also the precipitation of the lithium metal on the surface of a solid electrolyte interphase (SEI) layer, which will be described later, formed on the surface of the negative electrode. The expression "lithium metal is precipitated on the negative electrode" also includes the precipitation of the lithium metal on at least one location on the surface or inside of a cushioning function layer that is in electrical contact with the negative electrode and on the surface of a solid electrolyte interphase (SEI) layer, which will be described later, formed on the surface of the negative electrode or the cushioning function layer. For example, in FIG. 2, the lithium metal can be precipitated on the surface of the negative electrode 130 (an interface between the negative electrode 130 and the separator 140).

In a case where the lithium secondary battery 101 of the present embodiment is compared with a lithium ion battery (LIB) and a lithium metal battery (LMB), the following points are different.

In the lithium ion battery (LIB), a negative electrode has a host material for a lithium element (lithium ions or lithium metal), this material is filled with the lithium element when the battery is charged, and the host material releases the lithium element, thereby discharging the battery. The LIB is different from the lithium secondary battery 101 of the present embodiment in that the negative electrode has the host material for the lithium element.

The lithium metal battery (LMB) is manufactured by using, as a negative electrode, an electrode having lithium metal on the surface thereof or single lithium metal. That is, the LMB is different from the lithium secondary battery 101 of the present embodiment in that the negative electrode has the lithium metal, which is the negative electrode active material, immediately after assembling the battery, that is, before the initial charge of the battery. The LMB uses the electrode containing a lithium metal having high flammability and reactivity in the manufacturing. However, since the negative electrode which does not have a lithium metal is used in the lithium secondary battery 101 of the present embodiment, the lithium secondary battery in the present embodiment has more excellent safety and productivity.

In the present specification, the expression that the negative electrode "does not have a negative electrode active material" means the negative electrode does not have the negative electrode active material or does not substantially have the negative electrode active material. The fact that the negative electrode does not substantially have the negative electrode active material means that the amount of the negative electrode active material included in the negative electrode is sufficiently smaller than that of the positive electrode active material in terms of capacity ratio. The content of the negative electrode active material in the negative electrode is, for example, 10% by mass or less with respect to the total mass of the negative electrode. The content of the negative electrode active material in the negative electrode is preferably 5.0% by mass or less and may be 1.0% by mass or less, 0.1 % by mass or less, or 0.0% by mass or less relative to the total mass of the negative electrode. Since the negative electrode does not have the negative electrode active material or the amount of the negative electrode active material in the negative electrode is within the above-described range, the energy density of the lithium secondary battery 101 is high.

In the present specification, the "lithium secondary battery including a negative electrode which does not have a negative electrode active material" means that the negative electrode does not have the negative electrode active material before initial charge of the battery. Therefore, the phrase "negative electrode which does not have a negative electrode active material" may be rephrased as "negative electrode which does not have a negative electrode active material before initial charge of the battery", "negative electrode which does not have a negative electrode active material other than a lithium metal regardless of the charged state of the battery and does not have a lithium metal before initial charge", "negative electrode current collector which does not have a lithium metal before initial charge", or the like. Alternatively, in the above phrase, the term "before initial charge" may be replaced with the term "before initial charge or at the end of discharge". In addition, the "lithium secondary battery including a negative electrode which does not have a negative electrode active material" may be rephrased as an anode free lithium battery, a zero anode lithium battery, or an anodeless lithium battery.

In the present specification, "before initial charge" of the battery means a state from the time when the battery is assembled to the time when the battery is first charged. In addition, "at the end of discharge" of the battery means a state in which the battery is not discharged even when the voltage of the battery is further reduced, and the voltage of the battery at the time is, for example, 1.0 V or more and 3.8 V or less, and preferably 1.0 V or more and 3.0 V or less.

In the negative electrode of the present embodiment, regardless of the charged state of the battery, the content of the negative electrode active material other than the lithium metal is 10% by mass or less, and preferably 5.0% by mass or less, and may be 1.0% by mass or less, 0.1% by mass or less, or 0.0% by mass or less relative to the total mass of the negative electrode.

In addition, in the negative electrode of the present embodiment, before the initial charge or at the end of discharge, the content of lithium metal is 10% by mass or less, and preferably 5.0% by mass or less, and may be 1.0% by mass or less, 0.1% by mass or less, or 0.0% by mass or less relative to the total mass of the negative electrode. In the negative electrode, before the initial charge or at the end of discharge, the content of lithium metal is preferably 10% by mass or less relative to the total mass of the negative electrode (among these, the content of lithium metal is preferably 5.0% by mass or less, and may be 1.0% by mass or less, 0.1% by mass or less, or 0.0% by mass or less relative to the total mass of the negative electrode).

In the lithium secondary battery 101 of the present embodiment, in a case where the voltage of the battery is 1.0 V or more and 3.5 V or less, the content of lithium metal may be 10% by mass or less relative to the total mass of the negative electrode (preferably 5.0% by mass or less, and may be 1.0% by mass or less, 0.1% by mass or less, or 0.0% by mass or less); in a case where the voltage of the battery is 1.0 V or more and 3.0 V or less, the content of lithium metal may be 10% by mass or less relative to the total mass of the negative electrode (preferably 5.0% by mass or less, and may be 1.0% by mass or less, 0.1% by mass or less, or 0.0% by mass or less); or in a case where the voltage of the battery is 1.0 V or more and 2.5 V or less, the content of lithium metal may be 10% by mass or less relative to the total mass of the negative electrode (preferably 5.0% by mass or less, and may be 1.0% by mass or less, 0.1% by mass or less, or 0.0% by mass or less).

In addition, in the lithium secondary battery 101 of the present embodiment, a ratio M_{3.0}/M_{4.2} of a mass M_{3.0} of the lithium metal precipitated on the negative electrode in a state in which the voltage of the battery is 3.0 V to a mass M_{4.2} of the lithium metal precipitated on the negative electrode in a state in which the voltage of the battery is 4.2 V is preferably 20% or less, more preferably 15% or less, and still more preferably 10% or less. The ratio M_{3.0}/M_{4.2} may be 8.0% or less, 5.0% or less, 3.0% or less, or 1.0% or less.

Examples of the negative electrode active material include lithium metals, alloys containing a lithium metal, carbon-based materials, metal oxides, metals alloyed with lithium, alloys containing the metals, and the like. The carbon-based material is not particularly limited and examples thereof include graphene, graphite, hard carbon, mesoporous carbon, carbon nanotube, carbon nanohorn, and the like. The metal oxide is not particularly limited and examples thereof include titanium oxide-based compounds, tin oxide-based compounds, cobalt oxide-based compounds, and the like. Examples of metals alloyed with lithium include silicon, germanium, tin, lead, aluminum, and gallium.

The negative electrode of the present embodiment is not particularly limited as long as the negative electrode does not contain a negative electrode active material and can be used as a current collector. Examples thereof include at least one selected from the group consisting of metals such as Cu, Ni, Ti, Fe, and other metals that do not react with Li, alloys of these metals, and stainless steel (SUS). When SUS is used as the negative electrode, various types of SUS known in the related art can be used. These negative electrode materials may be used either singly or in combinations of two or more. In the present specification, the "metal that does not react with Li" means a metal that does not react with a lithium ion or lithium metal to form an alloy under the operation conditions of the lithium secondary battery 101.

The negative electrode of the present embodiment is preferably at least one selected from the group consisting of Cu, Ni, Ti, Fe, alloys thereof, and stainless steel (SUS), and more preferably at least one selected from the group consisting of Cu, Ni, alloys thereof, and stainless steel (SUS). The negative electrode is still more preferably Cu, Ni, alloys thereof, or stainless steel (SUS). When this negative electrode is used, the energy density and productivity of the battery tend to be further improved.

The average thickness of the negative electrode of the present embodiment is preferably 4 µm or more and 20 µm or less, more preferably 5 µm or more and 18 µm or less, and still more preferably 6 µm or more and 15 µm or less. In such an aspect, since the volume occupied by the negative electrode in the battery is decreased, the energy density of the battery is further improved.

### (Positive Electrode)

The positive electrode 120 is not particularly limited as long as the positive electrode is a positive electrode commonly used in a lithium secondary battery, and a known material can be selected as needed, depending on the application of the lithium secondary battery. From the viewpoint of improving the stability of the battery and the output voltage, the positive electrode 120 preferably has a positive electrode active material.

In the present specification, the "positive electrode active material" is a material that causes an electrode reaction, that is, an oxidation reaction and a reduction reaction at the positive electrode. Specific examples of the positive electrode active material in the present embodiment include a host material of a lithium element (typically, lithium ion).

Such a positive electrode active material is not particularly limited and examples thereof include metal oxides and metal phosphates. The metal oxides are not particularly limited and examples thereof include cobalt oxide-based compounds, manganese oxide-based compounds, nickel oxide-based compounds, and the like. The metal phosphates are not particularly limited and examples thereof include iron phosphate-based compounds and cobalt phosphate-based compounds. Examples of typical positive electrode active materials include LiCoO₂, LiNiₓCo_{y}Mn_{z}O (x + y + z = 1), LiNiₓMn_{y}O (x + y = 1), LiNiO₂, LiMn₂O₄, LiFePO, LiCoPO, LiFeOF, LiNiOF, and TiS₂. The positive electrode active materials may be used either singly or in combinations of two or more.

The positive electrode 120 may contain components other than the positive electrode active material. Such components are not particularly limited and examples thereof include known conductive aids, binders, and polymer electrolytes.

Examples of conductive aids used in the positive electrode 120 include, but are not limited to, carbon black, single-wall carbon nanotubes (SWCNT), multi-wall carbon nanotubes (MWCNT), carbon nanofibers (CF), acetylene black, and the like. The binder is not particularly limited and examples thereof include polyvinylidene fluoride, polytetrafluoroethylene, styrene butadiene rubber, acrylic resins, polyimide resins, and the like.

The content of the positive electrode active material in the positive electrode 120 may be, for example, 50% by mass or more and 100% by mass or less relative to the total mass of the positive electrode 120. The content of the conductive aid may be, for example, 0.5% by mass or more and 30% by mass or less relative to the total mass of the positive electrode 120. The content of the binder may be, for example, 0.5% by mass or more and 30% by mass or less relative to the total amount of the positive electrode 120. The content of the polymer electrolyte may be, for example, 0.5% by mass or more and 30% by mass or less relative to the total mass of the positive electrode 120.

### (Positive Electrode Current Collector)

The positive electrode current collector 110 is arranged on one side of the positive electrode 120. The positive electrode current collector 110 is not particularly limited as long as it is a conductor that does not react with lithium ions in the battery. Examples of such a positive electrode current collector include aluminum.

The average thickness of the positive electrode current collector 110 is preferably 4 µm or more and 20 µm or less, more preferably 5 µm or more and 18 µm or less, and still more preferably 6 µm or more and 15 µm or less. In such an aspect, since the volume of the positive electrode current collector 110 occupied in the lithium secondary battery 101 is decreased, the energy density of the lithium secondary battery 101 is further improved.

### (Separator)

The separator 140 is a member for ensuring the ionic conductivity of the lithium ions serving as the charge carrier between the positive electrode 120 and the negative electrode 130, while preventing the battery from being short-circuited by separating the positive electrode 120 and the negative electrode 130, and is formed of a material that does not have electronic conductivity and that does not react with lithium ions. The separator 140 also plays a role in retaining the electrolytic solution. Although the material itself constituting the separator does not have ionic conductivity, the separator retains the electrolytic solution so that the lithium ions are conducted through the electrolytic solution. The separator 140 is not particularly limited as long as the separator can play its role. For example, the separator 140 can be formed of a porous polyethylene (PE) film, a polypropylene (PP) film, or a laminated structure thereof.

The separator 140 may be covered with a separator coating layer. The separator coating layer may cover both of the surfaces of the separator 140 or may cover only one surface of the separator 140. The separator coating layer is not particularly limited as long as the member does not react with lithium ions. The separator coating layer preferably bonds the separator 140 to a layer adjacent to the separator 140 firmly. Such a separator coating layer is not particularly limited and examples include members including a binder such as polyvinylidene fluoride (PVDF), a composite material (SBR-CMC) of styrene butadiene rubber and carboxymethyl cellulose, polyacrylic acid (PAA), lithium polyacrylate (Li-PAA), polyimide (PI), polyamideimide (PAI), or aramid. In the separator coating layer, inorganic particles such as silica, alumina, titania, zirconia, magnesium oxide, magnesium hydroxide, and lithium nitrate may be added in the above-described binder. The separator 140 may be a separator having no separator coating layer, or a separator having the separator coating layer.

The average thickness of the separator 140 is preferably 30 µm or less, more preferably 25 µm or less, and still more preferably 20 µm or less. In such an aspect, since the volume of the separator 140 occupied in the lithium secondary battery 101 is decreased, the energy density of the lithium secondary battery 101 is further improved. Further, the average thickness of the separator 140 is preferably 5 µm or more, more preferably 7 µm or more, and still more preferably 10 µm or more. In such an aspect, the positive electrode 120 and the negative electrode 130 can be more reliably separated, and a short circuit of the battery can be further suppressed.

### (Electrolytic Solution)

The lithium secondary battery 101 preferably has an electrolytic solution. In the lithium secondary battery 101, the separator 140 may be impregnated with the electrolytic solution or the electrolytic solution may be sealed together with a laminate of the positive electrode current collector 110, the positive electrode 120, the separator 140, and the negative electrode 130 inside a sealed container. The electrolytic solution is a solution that contains an electrolyte and a solvent and has ionic conductivity, and acts as a conductive path for lithium ions. Therefore, in the aspect including the electrolytic solution, an internal resistance of the battery is further reduced, and the energy density, capacity, and cycle characteristics are further improved.

The electrolytic solution preferably contains a fluorinated alkyl compound having at least one of a monovalent group represented by Formula (A) below and a monovalent group represented by Formula (B) below as a solvent. 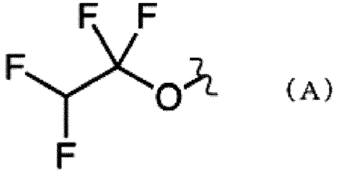 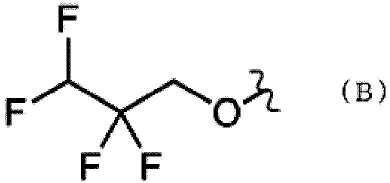 (here, in the formulae, a wavy line represents a bonding site in a monovalent group.)

In general, in an anode free lithium secondary battery containing the electrolytic solution, a solid electrolyte interphase layer (SEI layer) is formed on the surface of the negative electrode or the like by decomposing the solvent or the like in the electrolytic solution. Due to the SEI layer in the lithium secondary battery, further decomposition of the components in the electrolytic solution, irreversible reduction of lithium ions caused by the decomposition, generation of gas, and the like are suppressed. In addition, since the SEI layer has ionic conductivity, reactivity of lithium metal precipitation reaction on the surface of the negative electrode, on which the SEI layer is formed, is uniform in a planar direction of the surface of the negative electrode. When the above-described fluorinated alkyl compound is used as a solvent in the lithium secondary battery 101, the SEI layer is easily formed on the surface of the negative electrode, and the growth of dendritic lithium metal on the negative electrode is further suppressed. As a result, the cycle characteristics tend to be further improved.

In the present specification, a compound "contained as a solvent" means, in the usage environment of lithium secondary batteries, it is sufficient that the compound alone or a mixture of the compound with other compounds is a liquid, and further, it is sufficient that the electrolyte can be dissolved to form an electrolytic solution in a solution phase.

Examples of such a fluorinated alkyl compound include a compound having an ether bond (which will hereinafter be called "ether compound"), a compound having an ester bond, a compound having a carbonate bond, and the like. From the viewpoint of further improving solubility of the electrolyte in the electrolytic solution and from the viewpoint that the SEI layer is more easily formed, the fluorinated alkyl compound is preferably an ether compound.

Examples of the ether compound as the fluorinated alkyl compound include an ether compound having both the monovalent group represented by Formula (A) and the monovalent group represented by Formula (B) (which will hereinafter also be called "first fluorine solvent"), an ether compound that has the monovalent group represented by Formula (A) and does not have the monovalent group represented by Formula (B) (which will hereinafter also be called "second fluorine solvent"), an ether compound that does not have the monovalent group represented by Formula (A) and has the monovalent group represented by Formula (B) (which will hereinafter also be called "third fluorine solvent"), and the like.

Examples of the first fluorine solvent include
1,1,2,2-tetrafluoroethyl-2,2,3,3-tetrafluoropropyl ether,
1,1,2,2-tetrafluoroethyl-2,2,3,3-tetrafluoropropyl diethoxymethane,
1,1,2,2-tetrafluoroethyl-2,2,3,3-tetrafluoropropyl diethoxypropane, and the like.

From the viewpoint of effectively and reliably exhibiting the effect of the above-described fluorinated alkyl compound, 1,1,2,2-tetrafluoroethyl-2,2,3,3-tetrafluoropropyl ether is preferable as the first fluorine solvent.

Examples of the second fluorine solvent include
1,1,2,2-tetrafluoroethyl-2,2,2-trifluoroethyl ether, methyl-1,1,2,2-tetrafluoroethyl ether, ethyl-1,1,2,2-tetrafluoroethyl ether, propyl-1,1,2,2-tetrafluoroethyl ether,
1H,1H,5H-perfluoropentyl-1,1,2,2-tetrafluoroethyl ether,
1H, 1H,5H-octafluoropentyl-1,1,2,2-tetrafluoroethyl ether, and the like. From the viewpoint of effectively and reliably exhibiting the effect of the above-described fluorinated alkyl compound, 1,1,2,2-tetrafluoroethyl-2,2,2-trifluoroethyl ether,
methyl-1,1,2,2-tetrafluoroethyl ether, ethyl-1,1,2,2-tetrafluoroethyl ether, or
1H, 1H,5H-octafluoropentyl-1,1,2,2-tetrafluoroethyl ether is preferable as the second fluorine solvent.

Examples of the third fluorine solvent include
difluoromethyl-2,2,3,3-tetrafluoropropyl ether, trifluoromethyl-2,2,3,3-tetrafluoropropyl ether, fluoromethyl-2,2,3,3-tetrafluoropropyl ether, methyl-2,2,3,3-tetrafluoropropyl ether, and the like. From the viewpoint of effectively and reliably exhibiting the effect of the above-described fluorinated alkyl compound,
difluoromethyl-2,2,3,3-tetrafluoropropyl ether is preferable as the third fluorine solvent.

The electrolytic solution may contain a solvent that does not have both the monovalent group represented by Formula (A) and the monovalent group represented by Formula (B). Such a solvent is not particularly limited, and examples thereof include fluorine-free solvents such as triethylene glycol dimethyl ether, dimethoxyethane (DME), diethylene glycol dimethyl ether, acetonitrile, dimethyl carbonate, diethyl carbonate, ethyl methyl carbonate, ethylene carbonate, propylene carbonate, chloroethylene carbonate, methyl acetate, ethyl acetate, propyl acetate, methyl propionate, Ethyl propionate, trimethyl phosphate, triethyl phosphate, and the like, and fluorine-containing solvents such as methyl nonafluorobutyl ether, ethyl nonafluorobutyl ether,
1,1,1,2,2,3,4,5,5,5-decafluoro-3-methoxy-4-trifluoromethylpentane,
methyl-2,2,3,3,3-pentafluoropropyl ether, 1,1,2,3,3,3-hexafluoropropyl methyl ether,
ethyl-1,1,2,3,3,3-hexafluoropropyl ether, tetrafluoroethyl tetrafluoropropyl ether, and the like.

The solvents, including the fluorinated alkyl compounds described above, may be used either singly or in combinations of two or more.

The content of the fluorinated alkyl compound in the electrolytic solution is not particularly limited, and is preferably 40% by volume or more, more preferably 50% by volume or more, still more preferably 60% by volume or more, and still even more preferably 70% by volume or more relative to the total amount of the solvent components in the electrolytic solution. When the content of the fluorinated alkyl compound is within the above-described range, the SEI layer is more easily formed, and thus the cycle characteristics of the battery tend to be further improved. The upper limit of the content of the fluorinated alkyl compound is not particularly limited, and the content of the fluorinated alkyl compound in the electrolytic solution may be 100% by volume or less, 95% by volume or less, 90% by volume or less, or 80% by volume or less relative to the total amount of the solvent components in the electrolytic solution.

The electrolyte which is contained in the electrolytic solution is not particularly limited as long as the electrolyte is salt, and examples thereof include salts of Li, Na, K, Ca, and Mg, and the like. As the electrolyte, a lithium salt is preferably used. The lithium salt is not particularly limited, and examples thereof include Lil, LiCl, LiBr, LiF, LiBF₄, LiPF₆, LiAsF₆, LiSOsCFs, LiN(SO₂F)₂, LiN(SO₂CF₃)₂, LiN(SO₂CF₂CF₃)₂, LiB(C₂O₄)₂, LiBF₂(C₂O₄), LiB(O₂C₂H₄)₂, LiB(O₂C₂H₄)F₂, LiB(OCOCF₃)₄, LiNOs, Li₂SO₄, and the like. The lithium salts may be used either singly or in combinations of two or more.

The concentration of the electrolyte in the electrolytic solution is not particularly limited, and is preferably 0.5 M or more, more preferably 0.7 M or more, still more preferably 0.9 M or more, and even still more preferably 1.0 M or more. When the concentration of the electrolyte is within the above-described range, the SEI layer is more easily formed and the internal resistance tends to be further reduced. The upper limit of the concentration of the electrolyte is not particularly limited, and the concentration of the electrolyte may be 10.0 M or less, 5.0 M or less, or 2.0 M or less.

### (Production Method)

A method for producing the lithium secondary battery 101 as shown in FIG. 2 is not particularly limited as long as the method is a method for producing a lithium secondary battery having the above-described configuration and examples of the method include the method as follows.

First, the positive electrode 120 is prepared by a known production method or by purchasing a commercially available one. The positive electrode 120 may be produced in the following manner. The positive electrode active material described above, a known conductive aid, and a known binder are mixed together to obtain a positive electrode mixture. The mixing ratio may be, for example, 50% by mass or more and 99% by mass or less of the positive electrode active material, 0.5% by mass or more and 30% by mass or less of the conductive aid, and 0.5% by mass or more and 30% by mass or less of the binder relative to the total mass of the positive electrode mixture. The resulting positive electrode mixture is applied to one side of a metal foil (for example, Al foil) having a predetermined thickness (for example, 5 µm or more and 1 mm or less) and serving as a positive electrode current collector, and then press-molded. The resulting molded material is punched to a predetermined size to obtain a positive electrode 120 formed on a positive electrode current collector 110.

Next, the negative electrode 130 can be prepared by washing the negative electrode material described above, such as a metal foil (for example, an electrolytic Cu foil) having a thickness of 1 µm or more and 1 mm or less, with a solvent containing sulfamic acid.

Next, a separator 140 having the above-described configuration is prepared. The separator 140 may be produced using any method known in the related art, or a commercially available one may be used. The electrolytic solution may be prepared by dissolving the above-described electrolyte (typically, a lithium salt) in the above-described solvent.

Next, the positive electrode current collector 110 on which the positive electrode 120 is formed, the separator 140, and the negative electrode 130 obtained as described above are laminated in this order to obtain a laminate as shown in FIG. 2. The laminate obtained as described above is then sealed in the sealed container together with the electrolytic solution to obtain the lithium secondary battery 101. The sealed container is not particularly limited and examples include a laminate film.

### [Functional Configuration of BMS 400]

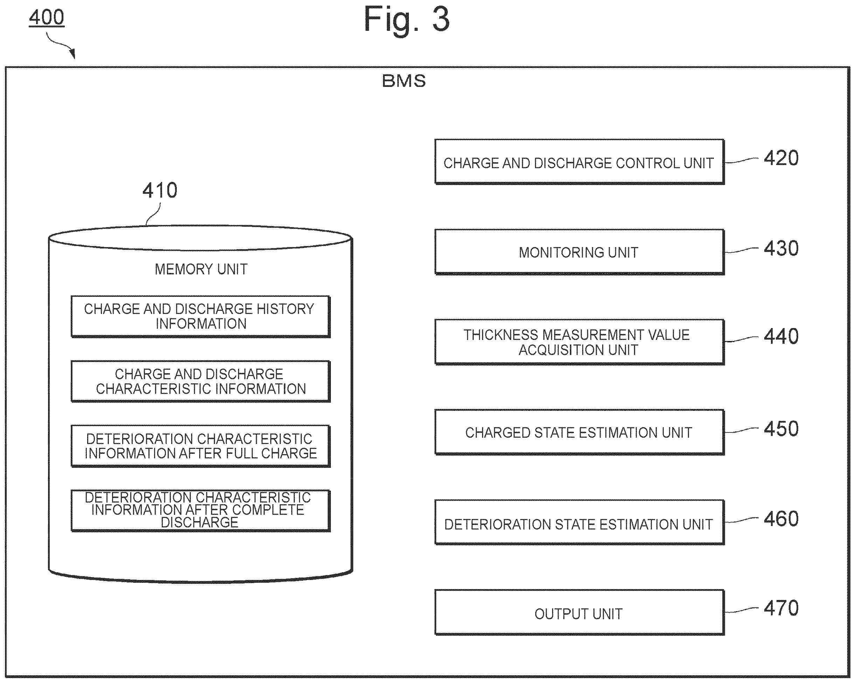

FIG. 3 is a block diagram illustrating an example of a functional configuration of the BMS 400 according to the present embodiment.

For example, the BMS 400 has the memory unit 410, a charge and discharge control unit 420, a monitoring unit 430, a thickness measurement value acquisition unit 440, a charged state estimation unit 450, a deterioration state estimation unit 460, and an output unit 470.

### (Memory Unit 410)

The memory unit 410 is a memory unit configured using the memory 401 described above, and stores, for example, charge and discharge history information, charge and discharge characteristic information, deterioration characteristic information after full charge, and deterioration characteristic information after complete discharge.

### (Charge and Discharge History Information)

The charge and discharge history information includes a current value, a voltage value, and a temperature value of each lithium secondary battery 101 detected by various sensors (current sensor 102, voltage sensor 103, temperature sensor 104, and the like) in the charge and discharge control of each lithium secondary battery 101, and calculated values calculated from these detected values. The calculated values may include, for example, a charge amount which is an integrated value of the current value in the charge cycle, a discharge amount which is an integrated value of the current value in the discharge cycle, and the like. As will be described later, the charge and discharge history information is calculated by, for example, the monitoring unit 430.

### (Charge and Discharge Characteristic Information)

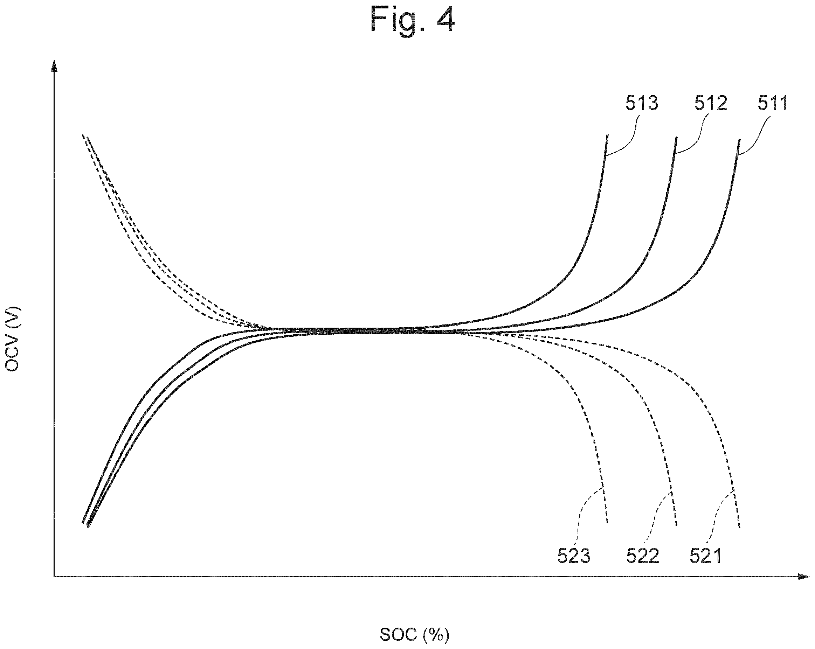

FIG. 4 is a diagram illustrating examples of charge and discharge characteristic information according to the present embodiment. In FIG. 4, the vertical axis represents an open circuit voltage (OCV) (V). Here, "open circuit voltage (OCV)" is also referred to as "open-circuit voltage", and refers to the equilibrium voltage when an external power supply is connected between the electrodes of a battery, the current is set to 0 A, and the battery has been allowed to relax for a long period of time within a time range in which self-discharge is not made. In FIG. 4, the horizontal axis represents a state of charge (SOC) (%). Here, "state of charge (SOC)" is also referred to as "charge rate", is an example of a charge index indicating a charged state of the battery, and is calculated based on an integrated value of a current value.

The charge and discharge characteristic information includes charge characteristic information and discharge characteristic information which are measured in advance using a lithium secondary battery for measurement. The charge characteristic information is information indicating a relationship between the OCV and the SOC in one charge cycle. The discharge characteristic information is information indicating a relationship between the OCV and the SOC in one discharge cycle.

As an example, in FIG. 4, three pieces of charge characteristic information 511, 512, and 513 having different numbers of charge and discharge cycles (the total number of charge and discharge cycles executed by the lithium secondary battery for measurement by that time) are shown by solid lines, respectively, and three pieces of discharge characteristic information 521, 522, and 523 having different numbers of charge and discharge cycles are shown by dotted lines, respectively. The charge characteristic information 511 and the discharge characteristic information 521 are charge and discharge characteristic information when the number of charge and discharge cycles is C1, the charge characteristic information 512 and the discharge characteristic information 522 are charge and discharge characteristic information when the number of charge and discharge cycles is C2, and the charge characteristic information 513 and the discharge characteristic information 523 are charge and discharge characteristic information when the number of charge and discharge cycles is C3. At this time, it is assumed that "C1 < C2 < C3" is established. As shown in FIG. 4, in the charge and discharge characteristic information, it is found that the full charge capacity of the lithium secondary battery 101 decreases as the number of charge and discharge cycles increases.

### (Deterioration Characteristic Information after Full Charge and Deterioration Characteristic Information After Complete Discharge)

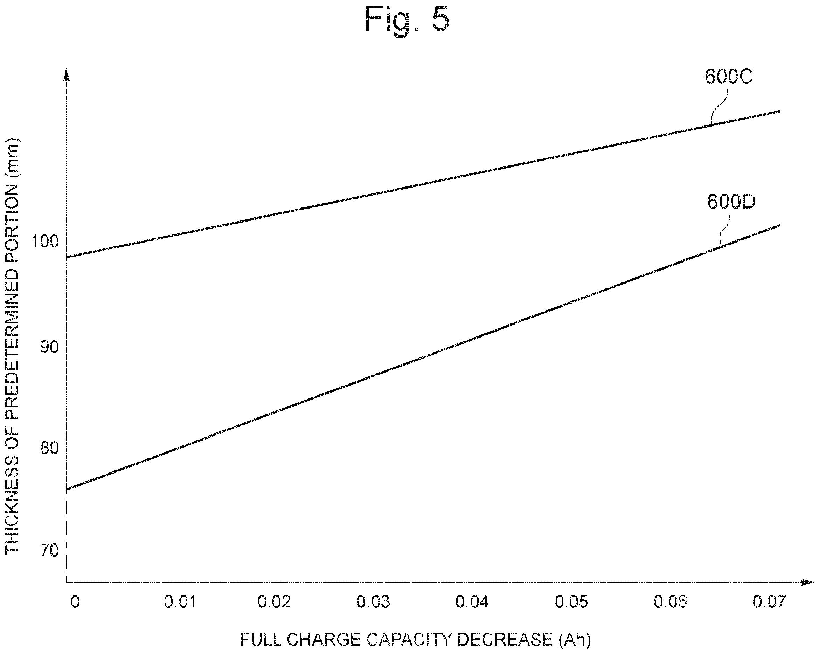

FIG. 5 is a diagram illustrating examples of deterioration characteristic information after full charge and deterioration characteristic information after complete discharge according to the present embodiment. Here, the deterioration characteristic information after full charge is characteristic information that defines a relationship between a thickness of a predetermined portion of the lithium secondary battery after full charge, which is measured in advance using the lithium secondary battery 101 for measurement, and a deterioration index indicating the deterioration state of the lithium secondary battery 101. In addition, the deterioration characteristic information after complete discharge is characteristic information that defines a relationship between a thickness of a predetermined portion of the lithium secondary battery after complete discharge, which is measured in advance using the lithium secondary battery 101 for measurement, and a deterioration index indicating the deterioration state of the lithium secondary battery 101.

In FIG. 5, the horizontal axis represents a full charge capacity decrease (Ah) as a deterioration index of the lithium secondary battery 101, and the vertical axis represents the thickness (mm) of the predetermined portion of the lithium secondary battery 101. Here, the full charge capacity decrease is a value obtained by subtracting the full charge capacity of the current battery from the full charge capacity in a state in which the battery is not deteriorated (unused and new). The deterioration index is not limited to the full charge capacity decrease, and may be another index as long as the deterioration index is an index indicating the degree of deterioration of the lithium secondary battery 101. For example, the deterioration index may be "state of health (SOH)". Here, "state of health (SOH)" is also referred to as a "capacity retention rate", and refers to a ratio (%) of the current full charge capacity (second full charge capacity) of the battery relative to the full charge capacity (first full charge capacity) in a state in which the battery is not deteriorated (new and unused). Further, for example, the deterioration index may be the number of charge and discharge cycles.

The reference numeral 600C indicates deterioration characteristic information after full charge, and the reference numeral 600D indicates deterioration characteristic information after complete discharge. In both the deterioration characteristic information after full charge 600C and the deterioration characteristic information after complete discharge 600D, the thickness of the predetermined portion increases as the full charge capacity decrease increases (SOH decreases). This is because as the number of charge and discharge cycles of the lithium secondary battery 101 increases, the SOH decreases and the thickness of the predetermined portion of the lithium secondary battery 101 increases.

Here, as the number of charge and discharge cycles of the lithium secondary battery 101 increases, the thickness of the predetermined portion of the lithium secondary battery 101 increases. This is mainly because deposits are generated on the negative electrode due to parasitic reactions in charge and discharge to increase the thickness of the negative electrode. In particular, since the negative electrode 130 does not contain a negative electrode active material in the lithium secondary battery 101 according to the present embodiment, described later, for example, during one charge and discharge cycle, the amount of lithium metal precipitated on the negative electrode 130 by the charge and discharge exhibits strong linearity with the amount of charge and discharge of the lithium secondary battery 101. Then, with the lapse of time (as charge and discharge cycles are repeated), a certain proportion of the lithium metal generated on the negative electrode 130 is accumulated as a deposit on the negative electrode 130 (for example, an organic or inorganic compound containing lithium or the like). Therefore, the linearity between the thickness of the predetermined portion and the deterioration index of the lithium secondary battery 101 is significant. For example, it can be said that the linearity is stronger than the linearity of a lithium ion secondary battery that does not have the structural feature of "the negative electrode does not contain a negative electrode active material". In FIG. 5, the inclination of the deterioration characteristic information after complete discharge 600D is larger than the inclination of the deterioration characteristic information after full charge 600C, and this is because the full charge capacity of the lithium secondary battery 101 decreases as the number of charge and discharge cycles increases.

### (Charge and Discharge Control Unit 420)

FIG. 3 is referred to again. The charge and discharge control unit 420 controls the charge and discharge of the lithium secondary battery 101. For example, the charge and discharge control unit 420 supplies a current from the charger 200 to the lithium secondary battery 101 to charge the lithium secondary battery 101. In addition, for example, the charge and discharge control unit 420 supplies the current from the lithium secondary battery 101 to the load 300 to discharge the lithium secondary battery 101.

### (Monitoring Unit 430)

The monitoring unit 430 acquires values (a current value, a voltage value, and a temperature value) detected by various sensors (current sensor 102, voltage sensor 103, and temperature sensor 104) included in the battery module 100 according to the charge and discharge of the lithium secondary battery 101, then generates charge and discharge history information based on the detected values, and stores the generated information in the memory unit 410.

### (Thickness Measurement Value Acquisition Unit 440)

The thickness measurement value acquisition unit 440 acquires the measurement value of the thickness of the predetermined portion of the lithium secondary battery 101 from the thickness sensor 105. As described above, the predetermined portion of the lithium secondary battery 101 from which the thickness sensor 105 measures the thickness may be any portion (including the whole) as long as the portion is defined to include at least a negative electrode 130 which will be described later. For example, the predetermined portion may be a portion from one end to the other end of a sealed container of the lithium secondary battery 101 or may be a portion formed only of the negative electrode 130.

### (Charged State Estimation Unit 450)

The charged state estimation unit 450 estimates the charged state of the lithium secondary battery 101 by calculating a charge index estimation value which is an estimation value of a charge index indicating the charged state of the lithium secondary battery 101. The calculation method of the charge index estimation value is not particularly limited, and for example, as described later, a method of comparing charge and discharge history information with charge and discharge characteristic information measured in advance may be used. The charge index may be, for example, an SOC which is a ratio of an amount of charge to a full charge capacity.

### (Deterioration State Estimation Unit 460)

The deterioration state estimation unit 460 estimates the deterioration state of the lithium secondary battery 101 by calculating a deterioration index estimation value which is an estimation value of a deterioration index indicating the deterioration state of the lithium secondary battery 101. Specifically, the deterioration state estimation unit 460 calculates a deterioration index estimation value for the lithium secondary battery 101 based on the measurement value of the thickness of the predetermined portion of the lithium secondary battery 101 and the charge index estimation value by referring to at least any one of the deterioration characteristic information after full charge and the deterioration characteristic information after complete discharge measured in advance using the lithium secondary battery 101 for measurement and stored in the memory unit 410. As described above, the deterioration index may be, for example, a full charge capacity decrease, SOH, the number of charge and discharge cycles, or the like.

### (Output Unit 470)

The output unit 470 outputs various information including the calculated SOH estimation value (an example of a deterioration index estimation value). For example, the output unit 470 may transmit the calculated information such as SOH to any information processing apparatus, or may display the calculated information on a display unit.

### [Deterioration State Estimation Process]

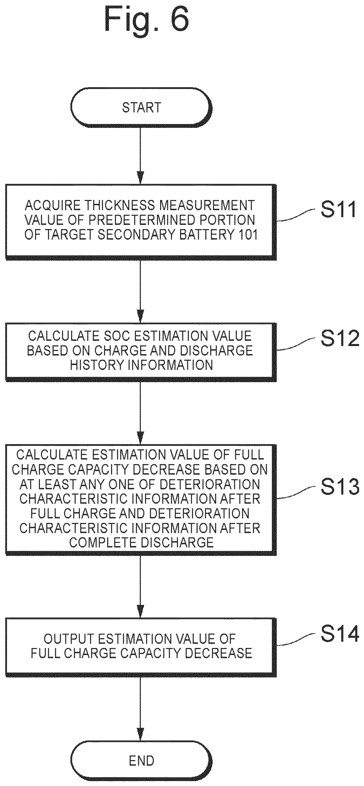

FIG. 6 is a diagram illustrating an example of an operation flow of a deterioration state estimation process by the power supply device 1 according to the present embodiment.

(S11) First, the thickness measurement value acquisition unit 440 acquires a measurement value of a thickness (thickness measurement value) of a predetermined portion of the lithium secondary battery 101 (target lithium secondary battery 101) whose deterioration state is to be estimated from the thickness sensor 105. The target lithium secondary battery 101 may be any lithium secondary battery 101 included in the battery module 100.

(S12) Next, the charged state estimation unit 450 calculates an SOC estimation value of the target lithium secondary battery 101 based on the latest charge and discharge history information of the target lithium secondary battery 101 by referring to the charge and discharge characteristic information for each of the number of charge and discharge cycles stored in the memory unit 410. Specifically, the charged state estimation unit 450 compares the latest charge and discharge history information of the target lithium secondary battery 101 with the charge and discharge characteristic information for each of the number of charge and discharge cycles stored in the memory unit 410, and then specifies charge and discharge characteristic information having the smallest difference from the charge and discharge history information. Then, the charged state estimation unit 450 specifies the charge amount and the discharge amount corresponding to the latest voltage value in the charge and discharge history information, calculates the ratio of the charge amount and the discharge amount to the full charge capacity, and determines the calculated value as the SOC estimation value.

(S13) Next, the deterioration state estimation unit 460 calculates an estimation value of a full charge capacity decrease for the target lithium secondary battery 101 based on the thickness measurement value acquired in Step S11 and the SOC estimation value calculated in Step S12 by referring to at least any one of the deterioration characteristic information after full charge and the deterioration characteristic information after complete discharge.

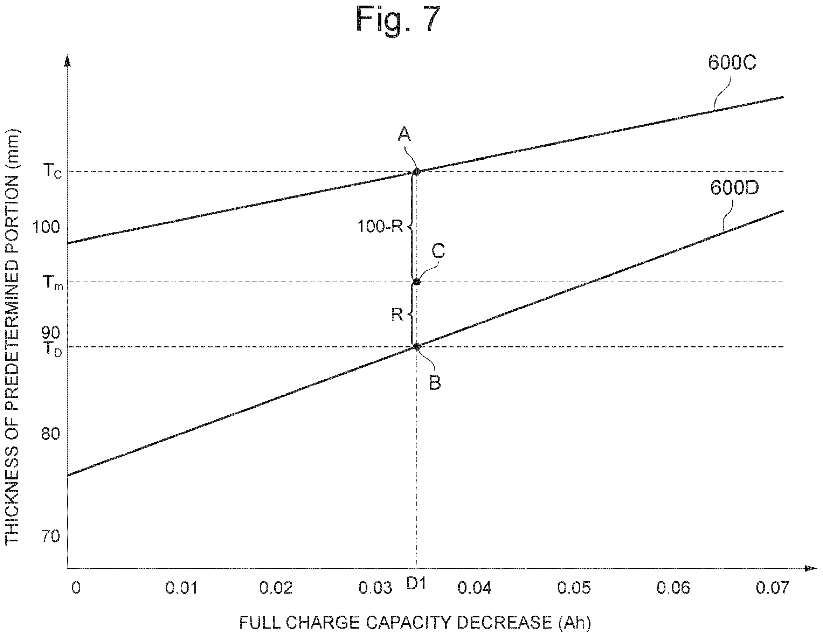

FIG. 7 is a diagram for describing a calculation method of an estimation value of a full charge capacity decrease. In FIG. 7, the deterioration characteristic information after full charge 600C and the deterioration characteristic information after complete discharge 600D, which are the same as those shown in FIG. 4, are shown. Hereinafter, with reference to FIG. 7, the calculation method of the estimation value of the full charge capacity decrease will be described in three cases including (1) a case where the SOC estimation value is 100 (%) (after the lithium secondary battery 101 is fully charged), (2) a case where the SOC estimation value is 0 (%) (after the lithium secondary battery 101 is completely discharged), and (3) a case where the SOC estimation value is more than 0 (%) and less than 100 (%) (neither after the lithium secondary battery 101 is fully charged nor after lithium secondary battery 101 is completely discharged).

### (1) Case where SOC Estimation Value is 100 (%)

In a case where the SOC estimation value is 100 (%), that is, after full charge, the deterioration state estimation unit 460 calculates a full charge capacity decrease corresponding to the thickness measurement value in the deterioration characteristic information after full charge 600C as an estimation value of the full charge capacity decrease. For example, when the thickness measurement value acquired in Step S11 is TC, in the deterioration characteristic information after full charge 600C in FIG. 7, a full charge capacity decrease at a point A corresponding to the thickness measurement value TC is D1. Therefore, the D1 is an estimation value of the full charge capacity decrease in a case where the thickness measurement value is TC and the SOC estimation value is 100 (%).

### (2) Case where SOC Estimation Value is 0 (%)

In a case where the SOC estimation value is 0 (%), that is, after complete discharge, the deterioration state estimation unit 460 calculates a full charge capacity decrease corresponding to the thickness measurement value in the deterioration characteristic information after complete discharge 600D as an estimation value of a full charge capacity decrease. For example, when the thickness measurement value acquired in Step S11 is TD, in the deterioration characteristic information after complete discharge 600D in FIG. 7, a full charge capacity decrease at a point B corresponding to the thickness measurement value TD is D1. Therefore, the D1 is an estimation value of the full charge capacity decrease in a case where the thickness measurement value is TD and the SOC estimation value is 0 (%).

### (3) Case where SOC Estimation Value is more than 0 (%) and less than 100 (%)

In a case where the SOC estimation value is more than 0 (%) and less than 100 (%), the deterioration state estimation unit 460 calculates an estimation value of a full charge capacity decrease as described below. It is assumed that the thickness measurement value acquired in Step S11 is Tm, and the SOC estimation value calculated in Step S12 is R. The battery thickness in the deterioration characteristic information after full charge 600C refers to the thickness after full charge, and the battery thickness in the deterioration characteristic information after complete discharge 600D refers to the thickness after complete discharge.

First, the deterioration state estimation unit 460 calculates a ratio of a difference between the thickness measurement value and the thickness after complete discharge with respect to a difference between the thickness after full charge and the thickness after complete discharge for any full charge capacity decrease. For example, in FIG. 7, in a case where the full charge capacity decrease is D1, the point A on the deterioration characteristic information after full charge 600C, and the point B on the deterioration characteristic information after complete discharge 600D each correspond to the full charge capacity decrease D1. Then, when the thickness after full charge at the point A is TC and the thickness after complete discharge at the point B is TD, the difference between the thickness after full charge TC and the thickness after complete discharge TD for the full charge capacity decrease D1 is TC - TD. Further, when a point at which the thickness measurement value is Tm at the full charge capacity decrease D1 is a point C, a difference between the thickness measurement value Tm and the thickness after complete discharge TD for the full charge capacity decrease D1 is Tm - TD. From the above, in the case where the full charge capacity decrease is D1, the above-described ratio (the ratio of the difference between thickness measurement value and the thickness after complete discharge to the difference between the thickness after full charge and the thickness after complete discharge) is (Tm - TD)/(TC - TD).

Next, the deterioration state estimation unit 460 calculates the ratio (Tm - TD)/(TC - TD) for any full charge capacity decrease, then compares the calculated value with the SOC estimation value R calculated in Step S12 to specify a full charge capacity decrease in a case where the ratio (Tm - TD)/(TC - TD) is equal to the SOC estimation value R, and determines a desired estimation value of the full charge capacity decrease.

In FIG. 7, a case where the full charge capacity decrease in a case where the ratio (Tm - TD)/(TC - TD) is equal to the SOC estimation value R is D1 is shown. In this case, in other words, as shown in FIG. 7, the ratio of the length of a line segment BC to the length of a line segment AB is equal to the SOC estimation value R. That is, the "length of line segment AC : length of line segment BC = 100 - R : R" is established.

Here, the reason that the (Tm - TD)/(TC - TD), which is the ratio (the ratio of the difference between the thickness measurement value and the thickness after complete discharge to the difference between the thickness after full charge and the thickness after complete discharge) and the SOC estimation value R are compared is that in the lithium secondary battery 101 according to the present embodiment, the thickness of the predetermined portion of the lithium secondary battery 101 at least including the negative electrode 130 exhibits strong linearity with respect to the SOC. That is, as described above, since the negative electrode 130 does not contain a negative electrode active material in the lithium secondary battery 101 according to the present embodiment, the amount of lithium metal precipitated on the negative electrode 130 by the charge and discharge exhibits strong linearity with the amount of charge and discharge of the lithium secondary battery 101. Therefore, in the lithium secondary battery 101 according to the present embodiment 101, the thickness of the predetermined portion of the lithium secondary battery 101 including at least the negative electrode 130 exhibits strong linearity with the charged state of the lithium secondary battery 101. Accordingly, as in the case (3) above in Step S13, even in a case where the SOC estimation value is more than 0 (%) and less than 100 (%) (neither after the lithium secondary battery 101 is fully charged nor after the lithium secondary battery 101 is completely discharged), the ratio of the thickness measurement value to the difference between the thickness after full charge and the thickness after complete discharge closely marches the SOC estimation value, and thus the accuracy of the calculated deterioration index (full charge capacity decrease or the like) is secured. In this regard, for example, since the negative electrode contains a negative electrode active material in a lithium ion secondary battery, and lithium ions are accumulated as an electrochemical reaction product by intercalation, changes (expansion, contraction, and the like) in the volume and dimension of the electrode do not have a linear relationship (proportional relationship or the like) with respect to an increase or a decrease in the quantity of electricity during charge and discharge. For example, in a case where the negative electrode active material is carbon, a large change in volume occurs at a structural change from LiC₁₂ to LiC₆ or the like, and thus, the dimensional change of the electrode is non-linear with respect to a charge index such as SOC.

(S14) Next, the output unit 470 outputs the calculated estimation value of the full charge capacity decrease. For example, the output unit 470 may transmit the calculated estimation value of the full charge capacity decrease to any information processing apparatus, or may display the calculated estimation value on any display unit. The deterioration state estimation process is then completed.

In the present specification, the term "high energy density" or "have a high energy density" means that the capacity is high relative to the total volume or total mass of the battery. The energy density is preferably 800 Wh/L or more or 350 Wh/kg or more, more preferably 900 Wh/L or more or 400 Wh/kg or more, and still more preferably 1000 Wh/L or more or 450 Wh/kg or more.

In the present specification, the term "excellent cycle characteristics" means that the rate of decrease in battery capacity is low before and after the number of charge and discharge cycles that can be expected during normal use. That is, it means that when comparing a first discharge capacity after initial charge with a discharge capacity after the number of charge and discharge cycles that can be expected during normal use, the discharge capacity after the charge and discharge cycles has not decreased significantly relative to the first discharge capacity after the initial charge. Here, "the number that can be expected during normal use" varies depending on the application for which the lithium secondary battery is used and it is, for example, 30 times, 50 times, 70 times, 100 times, 300 times, or 500 times. In addition, the "discharge capacity after charge and discharge cycles has not decreased significantly relative to the first discharge capacity after the initial charge" depends on the application for which the lithium secondary battery is used. For example, the discharge capacity after charge and discharge cycles may be 60% or more, 65% or more, 70% or more, 75% or more, 80% or more, or 85% or more of the first discharge capacity after the initial charge.

The embodiments described above are provided for facilitating the understanding of the present invention, and are not intended to limit the interpretation of the present invention. Each element included in the embodiments and the arrangement, materials, conditions, shape, size, and the like are not limited to those exemplified and can be appropriately changed. The configurations shown in the different embodiments may be partially replaced or combined.

## Claims

1. A deterioration state estimation device comprising:
a thickness measurement value acquisition unit that acquires a thickness measurement value which is a measurement value of a thickness of a predetermined portion including at least a negative electrode of a secondary battery whose negative electrode does not contain a negative electrode active material;
a charged state estimation unit that calculates a charge index estimation value which is an estimation value of a charge index indicating a charged state of the secondary battery;
a deterioration state estimation unit that, by referring to at least any one of deterioration characteristic information after full charge that defines a relationship between the thickness after full charge and a deterioration index indicating a deterioration state of the secondary battery and deterioration characteristic information after complete discharge that defines a relationship between the thickness after complete discharge and the deterioration index, calculates a deterioration index estimation value which is an estimation value of the deterioration index for the secondary battery, based on the thickness measurement value and the charge index estimation value; and
an output unit that outputs the calculated deterioration index estimation value.

2. The deterioration state estimation device according to claim 1, wherein the deterioration state estimation unit calculates, as the deterioration index estimation value, a deterioration index corresponding to the thickness measurement value in the deterioration characteristic information after full charge in a case where the charge index estimation value indicates after full charge, and
calculates, as the deterioration index estimation value, a deterioration index corresponding to the thickness measurement value in the deterioration characteristic information after complete discharge in a case where the charge index estimation value indicates after complete discharge.

3. The deterioration state estimation device according to claim 1, wherein in a case where the charge index estimation value does not indicate either after full charge or after complete discharge, the deterioration state estimation unit calculates, as the deterioration index estimation value, the deterioration index set such that, when the thickness in the deterioration characteristic information after full charge is set to a thickness after full charge and the thickness in the deterioration characteristic information after complete discharge is set to a thickness after complete discharge, a ratio of a difference between the thickness measurement value and the thickness after complete discharge to a difference between the thickness after full charge and the thickness after complete discharge is equal to the charge index estimation value.

4. The deterioration state estimation device according to any one of claims 1 to 3, wherein the charged state estimation unit calculates the charge index estimation value by acquiring charge and discharge history information showing a charge and discharge history of the secondary battery, and comparing the charge and discharge history information with charge and discharge characteristic information showing charge and discharge characteristics of the secondary battery.

5. The deterioration state estimation device according to any one of claims 1 to 4, wherein the deterioration index is calculated based on a first full charge capacity of the secondary battery which is not in a deterioration state and a second full charge capacity of a current secondary battery.

6. The deterioration state estimation device according to claim 5, wherein the deterioration index is a difference between the first full charge capacity and the second full charge capacity, or a ratio of the second full charge capacity to the first full charge capacity.

7. The deterioration state estimation device according to any one of claims 1 to 6, wherein the charge index is a state of charge (SOC).

8. The deterioration state estimation device according to any one of claims 1 to 7, wherein a carrier metal of the secondary battery is lithium.

9. A deterioration state estimation method comprising:
acquiring a thickness measurement value which is a measurement value of a thickness of a predetermined portion including at least a negative electrode of a secondary battery whose negative electrode does not contain a negative electrode active material;
calculating a charge index estimation value which is an estimation value of a charge index indicating a charged state of the secondary battery;
by referring to at least any one of deterioration characteristic information after full charge that defines a relationship between the thickness after full charge and a deterioration index indicating a deterioration state of the secondary battery and deterioration characteristic information after complete discharge that defines a relationship between the thickness after complete discharge and the deterioration index, calculating a deterioration index estimation value which is an estimation value of the deterioration index for the secondary battery, based on the thickness measurement value and the charge index estimation value; and
outputting the calculated deterioration index estimation value.

10. A program causing a computer to function as:
a thickness measurement value acquisition unit that acquires a thickness measurement value which is a measurement value of a thickness of a predetermined portion including at least a negative electrode of a secondary battery whose negative electrode does not contain a negative electrode active material;
a charged state estimation unit that calculates a charge index estimation value which is an estimation value of a charge index indicating a charged state of the secondary battery;
a deterioration state estimation unit that, by referring to at least any one of deterioration characteristic information after full charge that defines a relationship between the thickness after full charge and a deterioration index indicating a deterioration state of the secondary battery and deterioration characteristic information after complete discharge that defines a relationship between the thickness after complete discharge and the deterioration index, calculates a deterioration index estimation value which is an estimation value of the deterioration index for the secondary battery, based on the thickness measurement value and the charge index estimation value; and
an output unit that outputs the calculated deterioration index estimation value.
